# EUROPÄISCHE PATENTSCHRIFT

(11) **EP 0 631 386 B1**
(45) Veröffentlichungstag und Bekanntmachung des Hinweises auf die Patenterteilung: **19.08.1998**
(21) Anmeldenummer: 94109352.8
(22) Anmeldetag: 17.06.1994
(51) Int. Cl.: H03J 1/00

(54) **Verfahren zur automatischen und feldstärkeabhängigen Sendersuchlaufsteuerung und danach arbeitender Empfänger**
Method for automatic and field strength dependent control of scanning and receiver working according to this method
Méthode pour le contrôle de balayage d'émetteurs automatique et dépendant de l'intensité du champ et récepteur fonctionnant suivant ce procédé

(30) Priorität: 25.06.1993 DE 4321118
(43) Veröffentlichungstag der Anmeldung: 28.12.1994
(73) Patentinhaber: GRUNDIG Aktiengesellschaft, 90762 Fürth (DE)
(72) Erfinder: Hegendörfer, Max, Dipl.-Ing., GRUNDIG E.M.V., D-90748 Fürth (DE)

(56) Entgegenhaltungen:
- EP-A- 0 182 742
- EP-A- 0 311 504
- EP-A- 0 508 369
- US-A- 4 245 349
- US-A- 5 199 109

## Beschreibung

Die Erfindung betrifft ein Verfahren zur automatischen und feldstärkeabhängigen Sendersuchlaufsteuerung und einen nach diesem Verfahren arbeitenden Empfänger, gemäß der Oberbegriffe der Patentansprüche 1 und 5.

Es sind Sendersuchlaufsteuerungen bekannt, bei denen die Pegel der empfangenen Sendersignale mit einem vorgegebenen Schwellwert verglichen werden. Übersteigt der Pegel des empfangenen Sendersignals den Schwellwert, wird der Sender als empfangswürdig eingestuft, und der Sendersuchlauf wird beendet.

Der Artikel "Programm nach Wahl", erschienen in Funkschau, 1984, Heft 10, Seiten 35 - 37, beschreibt einen Empfänger, bei dem sichergestellt ist, daß immer der empfangsstärkste Sender eingestellt wird. Dazu wird die Ansprechschwelle des Suchlaufs beim ersten Anlaufen sehr hoch geschaltet. Wird dann nach dem ersten Banddurchlauf noch kein Sender gefunden, wird das Band erneut abgesucht und dabei die Ansprechschwelle etwas verringert. Dieser Vorgang wird bei langsam abnehmender Ansprechschwelle so lange wiederholt, bis das Empfangssignal eines Senders die gerade eingestellte Ansprechschwelle übersteigt. Unterschreitet das eingestellte Empfangssignal eine bestimmte, vorgegebene Schwelle, startet der Suchlauf automatisch, und zwar wieder mit der höchsten Ansprechschwelle.

Eine ähnliche Sendersuchlaufsteuerung ist aus der deutschen Offenlegungsschrift DE 27 46 282 A1 bekannt. Dort wird die Ansprechschwelle selbsttätig mit einer gegenüber der Suchlaufperiode kleinen Geschwindigkeit geändert, beginnend mit dem größten Pegel und allmählicher langsamer Abnahme dieses Pegels.

Die bekannten Sendersuchlaufsteuerungen haben jedoch den Nachteil, daß bis zum Auffinden des empfangsstärksten Senders oft mehrere Sendersuchläufe durch das gesamte zur Verfügung stehende Band nötig sind. Ein weiterer Nachteil ist darin zu sehen, daß die verwendeten Schwellwerte vorgegeben sind, wodurch eine Anpassung an die speziellen Empfangsverhältnisse, wie z.B. Länge des verwendeten Antennenkabels, nicht möglich ist.

Aufgabe der Erfindung ist es deshalb, ein Verfahren zur automatischen und feldstärkeabhängigen Sendersuchlaufsteuerung sowie einen danach arbeitenden Empfänger anzugeben, bei welchen die vom Stand der Technik bekannten Nachteile vermieden werden.

Erfindungsgemäß wird diese Aufgabe durch die Merkmale der Patentansprüche 1 und 5 gelöst.

Der Vorteil der Erfindung liegt insbesondere darin, daß empfangswürdige Sender, durch die Festsetzung der Ansprechschwelle unter Berücksichtigung des vorhandenen Störsignalpegels, schnell aufgefunden werden können.

Weitere Vorteile der Erfindung ergeben sich aus den Unteransprüchen sowie aus der nachfolgenden näheren Beschreibung mittels Figuren.

Es zeigt:
Figur 1 ein Blockschaltbild einer ersten erfindungsgemäßen Ausführungsform eines Empfängers,
Figur 2 ein Blockschaltbild einer zweiten erfindungsgemäßen Ausführungsform eines Empfängers, und
Figur 3 den auszuwertenden Empfangsbereich.

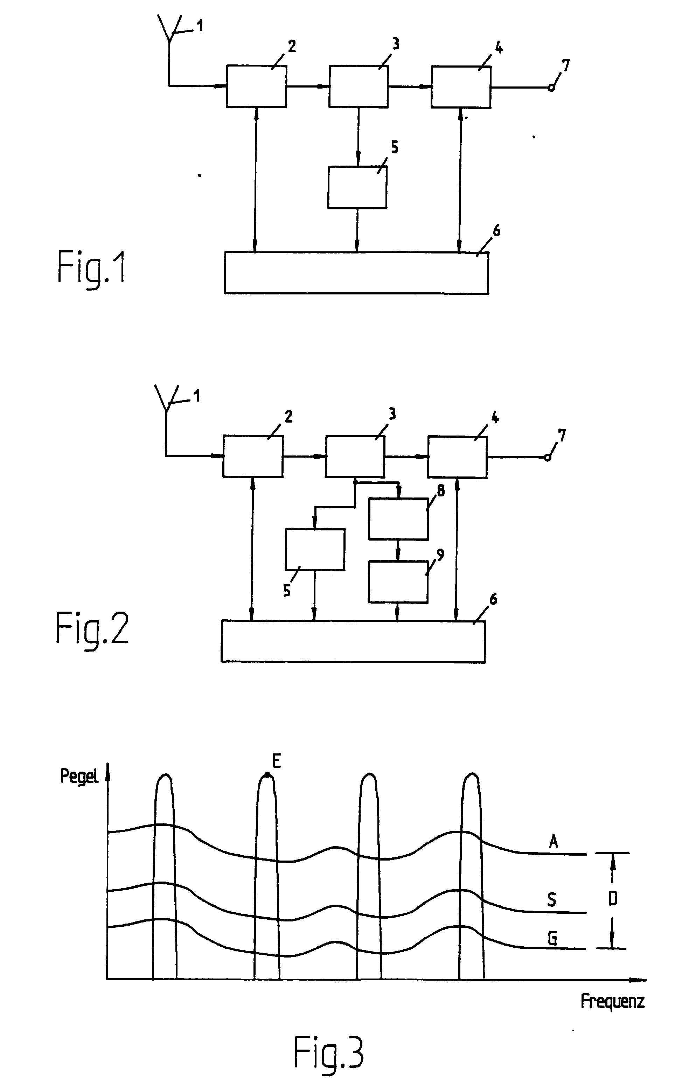

Der in Figur 1 dargestellte Empfänger besteht aus einer Antenne 1, einem Empfangsteil 2, einer Zwischenfrequenzstufe 3, einer Einrichtung 4 zur Auswertung der Zwischenfrequenzsignale. Die Einrichtung 4 kann beispielsweise Demodulatoren, Decoder, Verstärker usw. enthalten. Das ausgewertete Signal steht am Ausgang 7 zur Verfügung. Eine Einrichtung 6, die beispielsweise von einem Mikrocomputer gebildet werden kann, steuert den Empfänger. Insbesondere wird der Sendersuchlauf von der Einrichtung 6 gesteuert. Darüberhinaus weist der Empfänger eine Einrichtung 5 zur Detektion des Empfangspegels auf. Weitere, für das Verständnis der Erfindung unerhebliche Bestandteile, wie z.B. eine Eingabetastatur, sind aus Gründen der Vereinfachung nicht dargestellt.

Beim Einschalten des Empfängers oder bei der Inbetriebnahme des Empfängers wird der Pegel des Grundrauschens bestimmt, der in dem über die Antenne 1 empfangenen Signal enthalten ist. Dies kann beispielsweise dadurch erfolgen, daß der in Figur 3 dargestellte Empfangsbereich ausgewertet wird. Dazu wird das Empfangsteil 2 von der Steuereinrichtung 6 über den gesamten Empfangsbereich abgestimmt, wobei die vom Detektor 5 ermittelten und an die Steuereinrichtung 6 abgegeben Pegelwerte zwischengespeichert werden. Die Pegelwerte werden zur Erzeugung einer das Grundrauschen im Empfangsbereich kennzeichnenden Kurve G verwendet, die in der Steuereinheit 6 abgespeichert wird. Bei der Bestimmung der einzelnen Kurvenpunkte wird eine Mittelung der gemessenen Pegelwerte durchgeführt und die einzelnen Pegelwerte werden mit dem Mittelwert verglichen. Werden bei dem Vergleich Pegelwerte festgestellt, die deutlich über dem Mittelwert liegen, werden diese nicht für die weitere Mittelwertbildung und die Festlegung der Kurve G des Grundrauschens berücksichtigt. Die hohen Pegelwerte stellen nämlich entweder Sendersignale oder Störspitzen dar, die nicht zum Grundrauschen zu rechnen sind. Nach Maßgabe der durch die Pegelwerte der Kurve G beschriebenen Verteilung des Grundrauschens wird von der Steuereinheit 6 die Ansprechschwelle A festgesetzt. Diese liegt - entsprechend den Eigenschaften des Empfangsteils 2 - um einige dB höher (in Figur 3 gekennzeichnet mit D) als der jeweilige durch die Kurve G gegebene Rauschpegel. Soll die Kurve G des Grundrauschens für einen Empfangsbereich festgestellt werden, in dem die Sender sehr eng nebeneinander liegen, muß das Auffinden der Bereiche sichergestellt sein, durch die das Grundrauschen bestimmt werden kann. Bereiche in denen Sendersignale vorhanden sind, dürfen, wie oben bereits erwähnt, nicht berücksichtigt werden. Um dies sicherzustellen kann eine zusätzliche Untersuchung des empfangenen Signals auf senderspezifische Eigenschaften, z.B. Pilotsignale, erfolgen.

Die mittels der Kurve G festgesetzte Ansprechschwelle A wird von der Steuereinheit 6 für den durchzuführenden Sendersuchlauf verwendet. Die Steuereinheit 6 erzeugt so lange eine Abstimmspannung für das Empfangsteil 2, bis vom Detektor 5 ein Empfangspegel E ermittelt wird, der über der Ansprechschwelle A liegt.

Fällt während des Empfangs eines Senders der vom Detektor 5 ermittelte Pegel unter die Ansprechschwelle, wird von der Steuereinheit 5 automatisch ein neuer Sendersuchlauf gestartet. Zum automatischen Starten eines Sendersuchlaufs kann auch eine zweite Schwelle S verwendet werden, die kleiner als die Ansprechschwelle ist, aber noch eine gute Empfangsqualität gewährleistet. Während des Suchlaufs können die Ausgangssignale 7 von der Steuereinheit 6 über die Einrichtung 4 stummgeschaltet werden.

Durch die Auswertung im Sendersignal vorhandener Kennungen, beispielsweise RDS-Kennungen bei Rundfunksignalen oder VPS/Videotext-Kennungen in Fernsehsignalen, kann gezielt ein Sender gleichen Sendeinhalts gesucht werden, dessen Empfangspegel über der Ansprechschwelle liegt.

Eine Möglichkeit zur Verbesserung der oben beschriebenen Ansprechschwelle ist in Figur 2 dargestellt. Es wird eine Einrichtung 8 verwendet, die das Signalrauschen von vorhandenen Sendersignalen abtrennt. Die Einrichtung 8 kann beispielsweise mittels eines Hochpaßfilters realisiert werden. Das Hochpaßfilter wird im Signalweg vor einem Detektor 9 angeordnet. Die Sendersignale werden unterdrückt, wodurch die Ermittlung des signalbegleitenden Rauschpegels mittels Detektor 9 möglich ist. Detektor 5 ermittelt gleichzeitig den Empfangspegel. Für die Festlegung der Ansprechschwelle kann damit zusätzlich der Signal/Rauschabstand ausgewertet werden. Die Verwendung der Einrichtungen 8 und 9 hat den Vorteil, daß damit eine ständig Bewertung des Empfangssignals möglich ist, wodurch eine laufende Anpassung der verwendeten Schwellen möglich ist.

## Patentansprüche

1. Verfahren zur automatischen und feldstärkeabhängigen Sendersuchlaufsteuerung eines Empfängers, bei dem der Pegel des jeweils empfangenen Sendersignals mit einem Schwellwert verglichen wird, wobei ein Suchlauf beendet wird, falls der Pegel den Schwellwert überschreitet oder ein Suchlauf gestartet wird, falls der Pegel den Schwellwert oder einen zweiten Schwellwert unterschreitet,
**dadurch gekennzeichnet**,
daß nach der Inbetriebnahme und/oder nach dem Einschalten
- mittels eines Durchlaufens des Empfangsfrequenzbereichs der Pegelverlauf des Grundrauschens über den Empfangsfrequenzbereich bestimmt und abgespeichert wird, und anschließend
- der Schwellwert oder die Schwellwerte nach Maßgabe des abgespeicherten Pegelverlauf des Grundrauschens festgelegt werden.

2. Verfahren nach Anspruch 1,
**dadurch gekennzeichnet,**
daß das Signal/Rauschverhältnis des Empfangssignals ständig bestimmt wird, und daß der Schwellwert oder die Schwellwerte an auftretende Änderungen angepaßt werden.

3. Verfahren nach Anspruch 1 oder 2,
**dadurch gekennzeichnet**,
daß nach dem automatischen Auslösen eines Suchlaufs ein Sender gleichen Sendeinhalts eingestellt wird.

4. Verfahren nach einem der Ansprüche 1 bis 3,
**dadurch gekennzeichnet**,
daß während eines Suchslaufs eine Stummschaltung des Empfängers erfolgt.

5. Empfänger mit automatischer und feldstärkeabhängiger Sendersuchlaufsteuerung, mit
- einem Empfangsteil (2),
- einer ersten Einrichtung (3;4) zur Verarbeitung des empfangenen Hochfrequenzsignals,
- einer zweiten Einrichtung (5) zur Ermittlung des Pegels des jeweils empfangenen Sendersignals,
- einer dritten Einrichtung (6), die den ermittelten Pegel mit einem Schwellwert vergleicht, wobei ein Suchlauf beendet wird, falls der ermittelte Pegel den Schwellwert überschreitet oder ein Suchlauf gestartet wird, falls der ermittelte Pegel den Schwellwert oder einen zweiten Schwellwert unterschreitet,
**dadurch gekennzeichnet**, daß
- die dritte Einrichtung (6) nach der Inbetriebnahme und/oder nach dem Einschalten das Empfangsteil (2) so abstimmt, daß der gesamte Empfangsbereich durchlaufen wird,
- die dritte Einrichtung (6) die von der zweiten Einrichtung (5) ermittelten Pegel zur Festlegung des Verlaufs (G) des Grundrauschens auswertet sowie den Verlauf (G) des Grundrauschens abspeichert, und
- die dritte Einrichtung (6) nach Maßgabe des abgespeicherten Verlaufs (G) des Grundrauschens den oder die Schwellwerte festlegt.

6. Empfänger nach Anspruch 5,
**dadurch gekennzeichnet**,
daß eine vierte Einrichtung (8;9) zur Ermittlung des dem Empfangssignal anhaftenden Rauschpegels vorhanden ist, daß die dritte Einrichtung (6) den Rauschpegel in Verhältnis zum Pegel der zweiten Einrichtung (5) bewertet und die Schwellwerte nach Maßgabe der Bewertung ändert.

7. Empfänger nach Anspruch 6,
**dadurch gekennzeichnet,**
daß die vierte Einrichtung (8;9) ein Hochpaßfilter (8) zur Trennung von Rauschen und Sendersignal aufweist.

8. Empfänger nach einem der Ansprüche 5 bis 7,
**dadurch gekennzeichnet,**
daß die dritte Einrichtung (6) während eines Suchlaufs ein Steuersignal erzeugt, welches eine Stummschaltung der ersten Einrichtung (4) bewirkt.

9. Empfänger nach einem der Ansprüche 5 bis 8,
**dadurch gekennzeichnet,**
daß eine fünfte Einrichtung zur Auswertung von Senderkennsignalen vorhanden ist, daß empfangene Senderkennsignale zwischengespeichert werden, und daß bei der Auslösung eines Suchlaufs durch die dritte Einrichtung (6) ein aufgefundener Sender nur eingestellt wird, falls seine Senderkennsignale mit den zwischengespeicherten übereinstimmen.

10. Empfänger nach einem der Ansprüche 5 bis 9,
**dadurch gekennzeichnet,**
daß die dritte Einrichtung (6) von einem Mikrocomputer gebildet wird.

## Claims

1. Method for automatic and field-strength-dependent transmitter-search control of a receiver, in which the level of the transmitter signal received in each case is compared with a threshold value, a search being terminated if the level exceeds the threshold value or a search being started if the level is below the threshold value or a second threshold value, characterized in that, after commissioning and/or switching-on
- the level variation in the background noise over the reception frequency range is determined and stored by means of traversing the reception frequency range, and then
- the threshold value or the threshold values are set according to the stored level variation in the background noise.

2. Method according to Claim 1, characterized in that the signal/noise ratio of the received signal is constantly determined and in that the threshold value or the threshold values are adapted to the changes which occur.

3. Method according to Claim 1 or 2, characterized in that, after automatically initiating a search, a transmitter having the same transmission content is tuned to.

4. Method according to one of Claims 1 to 3, characterized in that, during a search, the receiver is muted.

5. Receiver having automatic and field-strength-dependent transmitter-search control, comprising
- a receiving section (2),
- a first device (3; 4) for processing the received radio-frequency signal,
- a second device (5) for determining the level of the transmitter signal received in each case,
- a third device (6) which compares the level determined with a threshold value, a search being terminated if the level determined exceeds the threshold value or a search being started if the level determined is below the threshold value or a second threshold value,
characterized in that
- after commissioning and/or switching-on, the third device (6) tunes the receiving section (2) in such a way that the entire reception range is traversed,
- the third device (6) evaluates the level determined by the second device (5) for setting the variation (G) in the background noise and stores the variation (G) in the background noise, and
- the third device (6) sets the threshold value or threshold values according to the stored variation (G) in the background noise.

6. Receiver according to Claim 5, characterized in that a fourth device (8; 9) is present for determining the noise level associated with the received signal and in that the third device (6) evaluates the noise level in relation to the level of the second device (5) and changes the threshold values according to the evaluation.

7. Receiver according to Claim 6, characterized in that the fourth device (8; 9) has a high-pass filter (8) for separating noise and transmitter signal.

8. Receiver according to one of Claims 5 to 7, characterized in that the third device (6) generates during a search a control signal which brings about muting of the first device (4).

9. Receiver according to one of Claims 5 to 8, characterized in that a fifth device is present for evaluating transmitter identifier signals, in that received transmitter identifier signals are temporarily stored and in that, if a search is initiated by the third device (6), any transmitter found is tuned to only if its transmitter identifier signals correspond to those temporarily stored.

10. Receiver according to one of Claims 5 to 9, characterized in that the third device (6) is formed by a microcomputer.

## Revendications

1. Procédé pour la commande de recherche d'un émetteur, qui est automatique et dépend de l'intensité de champ, dans un récepteur, selon lequel le niveau du signal respectivement reçu de l'émetteur est comparé à une valeur de seuil, dans lequel une recherche est terminée dans le cas où le niveau dépasse par le haut la valeur de seuil, ou une recherche est déclenchée dans le cas où le niveau tombe au-dessous de la valeur de seuil ou d'une deuxième valeur de seuil,
caractérisé en ce qu'après la mise en service et/ou après le branchement
- au moyen d'une recherche dans la gamme des fréquences de réception, l'allure du niveau du bruit de fond dans la gamme des fréquences de réception est déterminée et mémorisée, puis
- la valeur de seuil ou les valeurs de seuil sont fixées en fonction de l'allure mémorisée du niveau du bruit de fond.

2. Procédé selon la revendication 1, caractérisé en ce que le rapport signal/bruit du signal de réception est déterminé en permanence et que la valeur de seuil ou les valeurs de seuil sont adaptées à des variations qui apparaissent.

3. Procédé selon la revendication 1 ou 2, caractérisé en ce qu'après le déclenchement automatique d'une recherche, un émetteur possédant le même contenu d'émission est réglé.

4. Procédé selon l'une des revendications 1 à 3, caractérisé en ce qu'un assourdissement du récepteur est réalisé pendant une recherche.

5. Récepteur avec commande automatique, qui dépend de l'intensité de champ, de recherche d'un émetteur, comportant
- une partie de réception (2),
- un premier dispositif (3 ; 4) pour traiter le signal à haute fréquence reçu,
- un deuxième dispositif (5) pour déterminer le niveau du signal d'émetteur respectivement reçu,
- un troisième dispositif (6) qui compare le niveau déterminé à une valeur de seuil, une recherche étant terminée dans le cas où le niveau déterminé dépasse par le haut la valeur de seuil, ou une recherche démarre dans le cas où le niveau déterminé tombe au-dessous de la valeur de seuil ou d'une deuxième valeur de seuil ;
caractérisé en ce que
- après la mise en service et/ou le branchement de la partie de réception (2), le troisième dispositif (6) est accordé de telle sorte que la gamme de réception est parcourue dans sa totalité,
- le troisième dispositif (6) mémorise le niveau, déterminé par le deuxième dispositif (5), pour fixer l'allure (G) du bruit de fond, et mémorise l'allure (G) du bruit de fond, et
- le troisième dispositif (6) fixe la ou les valeurs de seuil en fonction de l'allure mémorisée (G) du bruit de fond.

6. Récepteur selon la revendication 5, caractérisé en ce qu'un quatrième dispositif (8 ; 9) est prévu pour la détermination du niveau de bruit qui affecte le signal de réception, que le troisième dispositif (6) évalue le niveau de bruit par rapport au niveau du deuxième dispositif (5) et modifie les valeurs de seuil en fonction de l'évaluation.

7. Récepteur selon la revendication 6, caractérisé en ce que le quatrième dispositif (8 ; 9) possède un filtre passe-haut (8) pour séparer le bruit et le signal d'émetteur.

8. Récepteur selon l'une des revendications 5 à 7, caractérisé en ce que le troisième dispositif (6) produit, pendant une recherche, un signal de commande, qui déclenche un assourdissement du premier dispositif (4).

9. Récepteur selon l'une des revendications 5 à 8, caractérisé en ce qu'un cinquième dispositif pour l'exploitation de signaux caractéristiques d'émetteur est présent, que des signaux caractéristiques d'émetteur reçus sont mémorisés temporairement et que dans le cas du déclenchement d'une recherche par le troisième dispositif (6), un émetteur trouvé est réglé uniquement dans le cas où ses signaux caractéristiques d'émetteur coïncident avec les signaux mémorisés temporairement.

10. Récepteur selon l'une des revendications 5 à 9, caractérisé en ce que le troisième dispositif (6) est formé par un micro-ordinateur.
